Europäisches Patentamt

European Patent Office

Office européen des brevets

(19)

(11) Publication number: **0 416 424 A2**

# EUROPEAN PATENT APPLICATION

(21) Application number: **90116417.8**

(22) Date of filing: **28.08.90**

(51) Int. Cl.5: **H03F 1/32**

(30) Priority: **06.09.89 US 403457**

(43) Date of publication of application:
**13.03.91 Bulletin 91/11**

(84) Designated Contracting States:
**BE CH DE DK FR GB LI NL SE**

(71) Applicant: **GENERAL INSTRUMENT CORPORATION**
**767 Fifth Avenue**
**New York New York 10153(US)**

(72) Inventor: **Jeffers, Michael F.**
**44 W. Wissahickon Avenue**
**Flourtown, Pennsylvania 19031(US)**

(74) Representative: **Hoeger, Stellrecht & Partner**
**Uhlandstrasse 14 c**
**W-7000 Stuttgart 1(DE)**

(54) Apparatus and method for reducing distortion in an analog optical transmission system.

(57) An apparatus and method are provided for reducing distortion in an analog optical transmission system. An analog electrical input signal is split into first and second signal portions. A laser is modulated with the first signal portion to produce a laser output signal. The laser output signal is split into first and second optical signals, and the second optical signal is converted into a corresponding electrical signal. Distortion components introduced by the laser are isolated by combining the corresponding electrical signal with the second signal portion of the original analog electrical input signal. A second laser is then modulated with the distortion components to produce a second laser output signal wherein the distortion components are of equal magnitude but opposite phase to those present in the first optical signal. The second laser output signal and first optical signal are combined to cancel the distortion components from the first optical signal.

# APPARATUS AND METHOD FOR REDUCING DISTORTION IN AN ANALOG OPTICAL TRANSMISSION SYSTEM

## BACKGROUND OF THE INVENTION

The present invention relates to analog optical transmission systems, and more particularly to an apparatus and method for reducing harmonic distortion components introduced by a laser transmitter.

Optical transmission systems are currently being implemented for use in various communication applications. For example, telephone systems are now in use that utilize fiber optic technology to transmit voice and data signals over long distances. Similarly, cable television networks are now available wherein fiber optic technology is used for the transmission of both analog and digital signals.

Prior to the implementation of optical transmission networks, cable television programs were carried as radio frequency ("RF") signals over electrical coaxial cables. In such systems, it is usually necessary to transmit signals over long distances. Since the strength of transmitted signals decreases in proportion to the length of the cable over which the signals are transmitted, amplification at repeated intervals along the cable is necessary to maintain adequate signal strength. The electronic amplifiers used for this purpose inherently distort the signals as they are being amplified. Harmonic distortion, in particular, results from nonlinearities in the amplifier that cause harmonics of the input frequencies to appear in the output. Other components in the communication network can similarly introduce distortion components.

One solution to the distortion problem in use "feedforward" amplifiers to amplify the signals at repeated intervals along the cable. Feedforward amplifiers are described, for example, in Blumenkranz U.S. Patent No. 4,472,725 entitled "LC Delay Line for Feedforward Amplifier", Tarbutton et al U.S. Patent No. 4,617,522 entitled "Temperature Regulated Feedforward Amplifier", Mannerstrom U.S. Patent No. 4,625,178 entitled "Feedforward Gain Block with Mirror Image Error Amplifier", and Blumenkranz et al U.S. Patent No. 4,792,751 entitled "Apparatus for Field Testing the Performance of a Feedforward Amplifier".

In the operation of a feedforward amplifier, a signal component representative of the distortion introduced by the amplifier is extracted from the amplified signal. That component is then typically phase inverted and the phase inverted distortion component is combined with the amplified signals. The phase inverted component cancels the distortion component in the amplified signal, leaving a relatively distortion free amplified signal for transmission along the cable.

Optical transmission systems provide a new problem in coping with distortion. In particular, harmonic distortion is a major limitation in analog amplitude modulated optical communication transmission systems. Such distortion, and particularly second order distortion, is introduced by the laser which transmits signals over the optical communication system.

It would be advantageous to provide an apparatus and method for reducing harmonic distortion in an analog optical transmission system. It would be further advantageous to provide such an apparatus and method that is economical, readily manufacturable, and reliable. The present invention provides such an apparatus and method.

## SUMMARY OF THE INVENTION

In accordance with the present invention, apparatus and a method are provided for reducing distortion in an analog optical transmission system. An analog electrical input signal is split into first and second signal portions. A laser is modulated with the first signal portion to produce a laser output signal. The laser output signal is split into first and second optical signals, and the second optical signal is converted into a corresponding electrical signal. This electrical signal is combined with the second signal portion of the original analog electrical input signal, to isolate distortion components introduced by the laser. A second laser is then modulated with the distortion components to produce a second laser output signal, which is combined with the first optical signal to cancel the distortion components therefrom.

The first signal portion, laser output signal, second optical signal, and corresponding electrical signal follow a first circuit path having an electrical length $L_1$. The second signal portion follows a second circuit path having an electrical length $L_2$. In a preferred embodiment of the invention, $L_1$ is approximately equal to $L_2$.

Similarly, the first optical signal follows a third circuit path having an electrical length $L_3$. The second optical signal, corresponding electrical signal, isolated distortion components, and the second laser output signal follow a fourth signal path having an electrical length $L_4$. In a preferred embodiment, the electrical length $L_3$ is approximately equal to the electrical length $L_4$.

Means can be provided in accordance with the present invention for adjusting the magnitude and/or phase of the electrical signal that corresponds to the second optical signal. Means can also be provided for adjusting the magnitude and/or phase of the distortion components used to modulate the second laser. Typically, the second signal portion comprises only a small sample of the original analog electrical input signal, and the second optical signal comprises only a small sample of the laser output signal. In this manner, the majority of the power contained in the original input signal is available for transmission over the optical communication network.

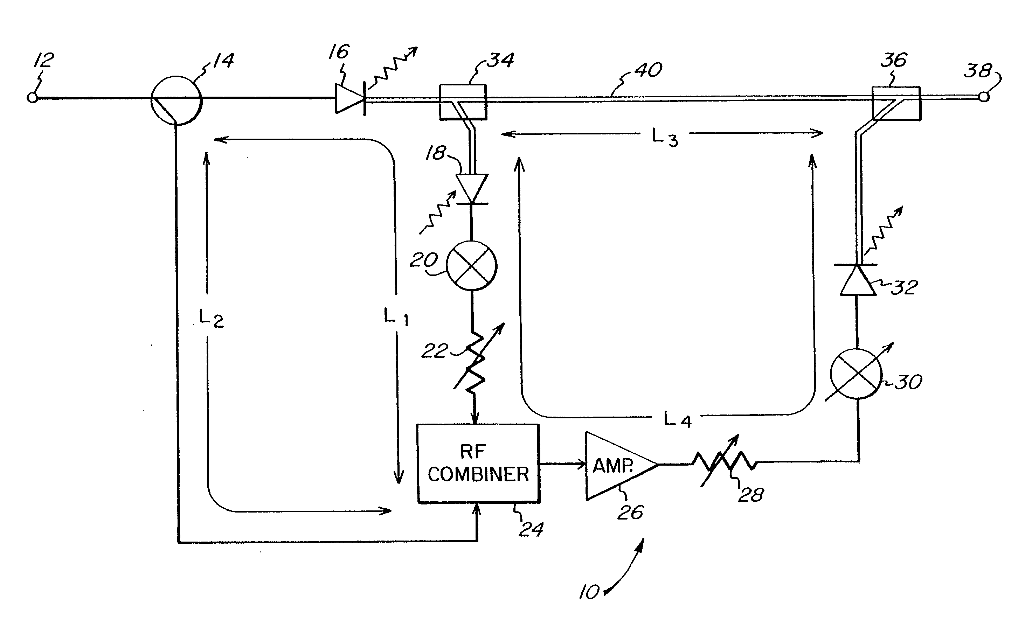

## BRIEF DESCRIPTION OF THE DRAWING

The drawing is a block diagram of apparatus in accordance with the present invention, in which electrical circuit paths are designated by a single line, and optical paths are designated by a double line.

## DETAILED DESCRIPTION OF THE INVENTION

Referring to the drawing, a block diagram generally designated 10 illustrates apparatus in accordance with the present invention for reducing distortion in an analog optical transmission system. The apparatus is useful in optical transmission systems for a variety of applications. For example, the apparatus can be used in connection with a cable television system, in which television signals in a conventional RF format are used to modulate a laser transmitter for optical communication via a fiber optic cable.

In such a system, an RF input terminal 12 is provided for receipt of a conventional cable signal consisting of many television RF signals. This signal is coupled to a directional RF splitter 14, that splits the analog electrical input signal from terminal 12 into first and second signal portions. The first signal portion is coupled to a laser transmitter 16, and modulates the laser to provide communication over an optical path 40. Laser transmitter 16 can comprise, for example, a conventional laser diode module of a type well known in the art. The second signal portion from directional RF splitter 14 is coupled to one side of an RF combiner 24. In a preferred embodiment, the second signal portion will only comprise a small part of the total RF power in the input signal, so that most of the power will modulate laser diode 16 for use in communication over optical fiber 40.

Laser transmitter 16 will inherently introduce harmonic distortion into the communication signal. An optical splitter 34 splits the laser output signal from transmitter 16 into first and second optical signals. The first optical signal proceeds along the transmission optical fiber path 40. The second optical signal comprises only a small portion of the total power contained in the laser output signal, and is coupled to an optical-to-RF detector 18, that converts the second optical signal into a corresponding electrical signal. Optical-to-RF detector 18 can comprise a conventional opto-detector well known in the art.

The electrical signal output from optical-to-RF detector 18 is coupled to RF combiner 24 through a conventional RF phase inverter 20 and RF attenuator 22. Attenuator 22 enables adjustment of the magnitude of the corresponding electrical signal to equal the magnitude of the second signal portion of the original analog electrical input signal that is coupled to RF combiner 24 from directional RF splitter 14.

When the fundamental components of each signal at the inputs to RF combiner 24 are equal in magnitude and opposite in phase, the output of the combiner will comprise only the second and higher order distortion components of laser transmitter 16. This result is clear since the second signal portion from splitter 14 and the corresponding electrical signal from optical detector 18 are derived from the same input signal; the only significant difference being the components added by laser transmitter 16 in the conversion of the electrical RF signal to an optical signal.

The distortion components isolated by RF combiner 24 are amplified by a conventional RF amplifier 26, and used to modulate a second laser 32 to produce a second laser output signal that is coupled back into the main optical path 40 via an optical combiner 36. A conventional RF attenuator 28 and adjustable phase control circuit 30 are provided to enable the magnitude and phase of the distortion components to be adjusted so that their optical equivalent, at the output of laser 32, is equal in magnitude and opposite in phase to the original distortion components output from laser 16 and coupled to main optical path 40 by optical splitter 34. In this manner, the original harmonic distortion generated by laser transmitter 16 is cancelled from the main optical path 40, and the resulting clean signal can be coupled to an optical transmission system via terminal 38.

For optimum operation, the electrical lengths of various circuit elements should be matched. In particular, the first signal portion from directional RF splitter 14, laser output signal from laser 16, second optical signal from optical splitter 34, and corresponding electrical signal from optical-to-RF detector 18 follow a first circuit path having an

electrical length $L_1$. The second signal portion from directional RF splitter 14 follows a second circuit path having an electrical length $L_2$. Similarly, the first optical signal coupled to main optical path 40 by optical splitter 34 follows a third circuit path having an electrical length $L_3$, and the second optical signal from optical splitter 34, corresponding electrical signal from optical-to-RF detector 18, isolated distortion components from RF. combiner 24, and second laser output signal from laser 32 follow a fourth signal path having an electrical length $L_4$. The layout of the circuit is designed so that $L_1 \approx L_2$ and $L_3 \approx L_4$. The matched lengths should also be as short as practical. By following these guidelines, only a minor phase control will need to be provided via adjustable phase control circuit 30 in the distortion cancelling path to achieve optimum performance.

It should now be appreciated that the present invention provides an apparatus and method for reducing distortion in an analog optical transmission system. In accordance with the present invention, the optical signal produced by laser transmitter 16 is converted back to an electrical signal for use in isolating the distortion components introduced by the laser transmitter. Then, the isolated distortion components are reconverted by a second laser to an optical signal comprising the distortion components with the same magnitude but opposite phase as they appear in the main optical transmission path. By combining the two optical signals, the distortion components are effectively cancelled from the main optical signal path.

Although the invention has been described in connection with a particular embodiment thereof, it will be appreciated by those skilled in the art that numerous modifications and adaptations may be made thereto, without departing from the spirit and scope of the invention as set forth in the following claims.

## Claims

1. Apparatus for reducing distortion in an analog optical transmission system, comprising:
means for splitting an analog electrical input signal into first and second signal portions;
means for modulating a laser with said first signal portion to produce a laser output signal;
means for splitting said laser output signal into first and second optical signals;
means for converting said second optical signal into a corresponding electrical signal;
means for combining said corresponding electrical signal and said second signal portion to isolate distortion components introduced by said laser;
means for modulating a second laser with said distortion components to produce a second laser output signal; and
means for combining said second laser output signal with said first optical signal to cancel said distortion components from the first optical signal.

2. The apparatus of claim 1 wherein said first signal portion, laser output signal, second optical signal and corresponding electrical signal follow a first circuit path having an electrical length $L_1$, said second signal portion follows a second circuit path having an electrical length $L_2$, and $L_1 \approx L_2$.

3. The apparatus of claim 2 wherein said first optical signal follows a third circuit path having an electrical length $L_3$, said second optical signal, corresponding electrical signal, isolated distortion components and second laser output signal follow a fourth signal path having an electrical length $L_4$, and $L_3 \approx L_4$.

4. The apparatus according to any of the preceding claims further comprising:
means for adjusting the magnitude of said corresponding electrical signal.

5. The apparatus according to any of the preceding claims further comprising:
means for adjusting the magnitude of the distortion components used to modulate said second laser.

6. The apparatus according to any of the preceding claims further comprising:
means for adjusting the phase of the distortion components used to modulate said second laser.

7. The apparatus according to any of the preceding claims wherein said analog electrical input signal splitting means provides only a small sample of the input signal to said combining means.

8. The apparatus of claim 7 wherein said laser output signal splitting means provides only a small sample of the laser output signal to said converting means.

9. Apparatus for reducing distortion in an analog optical transmission system, comprising:
means for modulating a first laser with an RF input signal to produce an optical communication signal;
means for producing an electrical signal corresponding to said optical communication signal;
means for combining said electrical signal with a portion of said RF input signal to produce a difference signal principally comprising distortion components introduced by said first laser;
means for modulating a second laser with said difference signal to produce an optical output signal corresponding to said difference signal; and
means for mixing said optical output signal with the optical communication signal to cancel the distortion components from the optical communication signal.

10. The apparatus of claim 9 further comprising:
means for providing the electrical signal and RF input signal portion to said combining means at opposite phases with respect to one another.

11. The apparatus of claim 9 or 10 further comprising:

means for equalizing the magnitudes of said electrical signal and RF input signal portion prior to combining them.

12. The apparatus of any of claims 9 to 11 further comprising:

means for equalizing the magnitudes of said optical output and optical communication signals prior to mixing them.

13. The apparatus of any of claims 9 to 12 further comprising:

means for providing the optical output and optical communication signals to said mixing means at opposite phases with respect to one another.

14. A method for reducing distortion in an analog optical transmission system comprising the steps of:

modulating a first laser with an RF input signal to produce an optical communication signal;

producing an electrical signal corresponding to said optical communication signal;

combining said electrical signal with a portion of said RF input signal to produce a difference signal principally comprising distortion components introduced by said first laser;

modulating a second laser with said difference signal to produce an optical output signal corresponding to said difference signal; and

mixing said optical output signal with the optical communication signal to cancel the distortion components from the optical communication signal.

15. The method of claim 14 comprising the further step of:

providing said electrical signal and RF input signal portion at equal magnitudes and opposite phases with respect to one another before said combining step.

16. The method of claim 14 or 15 comprising the further step of:

providing the optical output and optical communication signals at equal magnitudes and opposite phases with respect to one another before said mixing step.